# EUROPÄISCHE PATENTSCHRIFT

(11) **EP 0 654 175 B1**
(45) Veröffentlichungstag und Bekanntmachung des Hinweises auf die Patenterteilung: **22.10.1997**
(21) Anmeldenummer: 93917429.8
(22) Anmeldetag: 05.08.1993
(51) Int. Cl.: H01L 23/36, H01L 25/04, H02M 7/00

(54) **STROMRICHTER**
POWER CONVERTER
CONVERTISSEUR DE PUISSANCE

(30) Priorität: 06.08.1992 AT 1595/92
(43) Veröffentlichungstag der Anmeldung: 24.05.1995
(73) Patentinhaber: J.M. Voith GmbH, 89509 Heidenheim (DE)
(72) Erfinder: JELINEK, Heinrich, A-1130 Wien (AT)
(74) Vertreter: Rieberer, Stefan, Dipl.-Ing.
(86) Internationale Anmeldenummer: AT9300127
(87) Internationale Veröffentlichungsnummer: WO9403925

(56) Entgegenhaltungen:
- EP-A- 0 110 452
- DE-B- 2 460 631
- DE-C- 2 502 472
- US-A- 4 183 042

## Beschreibung

Die Erfindung betrifft einen Stromrichter, der aus einzelnen Halbleitermodulen und Zwischenkreiskondensatoren besteht.

Bei einem modernen Stromrichter besteht die Forderung die Verbindungen zwischen den einzelnen Bauelementen so gering wie möglich zu halten, da es aufgrund der hohen Schaltfrequenzen zu Störbeeinflussungen kommen kann. Außerdem ist bei Verwendung des Stromrichters für Antriebe im Verkehrswesen der zur Verfügung stehende Raum oft sehr gering.

In der EP-A 0 110 452 ist die Anordnung der einzelnen Halbleiter auf einem Kühlkörper von einer Diodenbrücke dargestellt. Die elektrischen Verbindungen zwischen den Halbleitern sind dabei relativ kurz.

Die Aufgabe der Erfindung besteht nun darin, einen neuen, besonders kompakten Aufbau eines Stromrichters zu schaffen.

Die Aufgabe wird durch die Erfindung gelöst, welche dadurch gekennzeichnet ist, daß auf einem rechteckigen Grundkörper entlang einer Längsseite eine erste Mehrzahl von Halbleitermodulen befestigt ist, welche in thermischem Kontakt mit dem Grundkörper stehen, und daß auf der Unterseite entlang der zweiten Längsseite eine erste Mehrzahl von Zwischenkreiskondensatoren stehend angeordnet ist, welche ebenfalls in thermischem Kontakt mit dem Grundkörper stehen, und daß ein zweiter Grundkörper vorgesehen ist, auf dem eine zweite Mehrzahl von Halbleitermodulen und eine zweite Mehrzahl von Zwischenkreiskondensatoren in der gleichen Art angeordnet ist, und daß beide Grundkörper überlappend entlang ihrer Längsseiten so miteinander verbunden sind, daß die Halbleitermodule gegenüber liegen, und daß die Zwischenkreiskondensatoren auf dem einen Grundkörper mit den Halbleitermodulen auf dem anderen Grundkörper elektrisch verbunden sind. Dadurch wird einerseits der gewünschte kompakte Aufbau und andererseits eine ausreichend gute Kühlung der Halbleitermodule erreicht.

Nach einer Ausgestaltung der Erfindung sind die Zwischenkreiskondensatoren in Vertiefungen im Grundkörper angeordnet. Dadurch erhalten diese eine optimale Befestigung im Grundkörper, werden auch besser gekühlt und der Stromrichteraufbau wird noch kompakter.

Von Vorteil ist, daß die Halbleitermodule mit einer die Ansteuerung für diese aufweisenden Leiterplatte verbunden sind, die parallel zur Grundplatte angeordnet ist. Durch diese Maßnahme werden kurze Verbindungen zwischen Ansteuerelektronik und Halbleitermodul erreicht, wodurch nur eine sehr geringe Störbeeinflussung der Ansteuersignale gegeben ist.

Eine Ausgestaltung der Erfindung besteht darin, daß jeder Grundkörper gegenüber den Halbleitermodulen Längsschlitze aufweist, die durch Quervertiefungen im Randbereich der Grundkörper miteinander verbunden und abgeschlossen sind, und daß zwei Grundkörper derart miteinander verbunden sind, daß die Längsschlitze gegenüber liegen, und daß an den Stirnseiten von zwei miteinander verbundenen Grundkörpern mindestens je eine Bohrung bis zur Quervertiefung vorgesehen ist, deren Mittelpunkt auf der Verbindung zwischen den beiden Grundkörpern liegt, und daß die Bohrungen für den Zu- und Abfluß eines flüssigen Kühlmediums vorgesehen sind. Es wird dadurch die Verlustwärme der Halbleitermodule aus den Grundkörpern ausreichend abgeführt. Weiters ist auch die Herstellung der Kühlkanäle, welche die Längsschlitze sind, relativ einfach.

Die Erfindung wird nun an Hand der Zeichnungen noch näher erläutert.

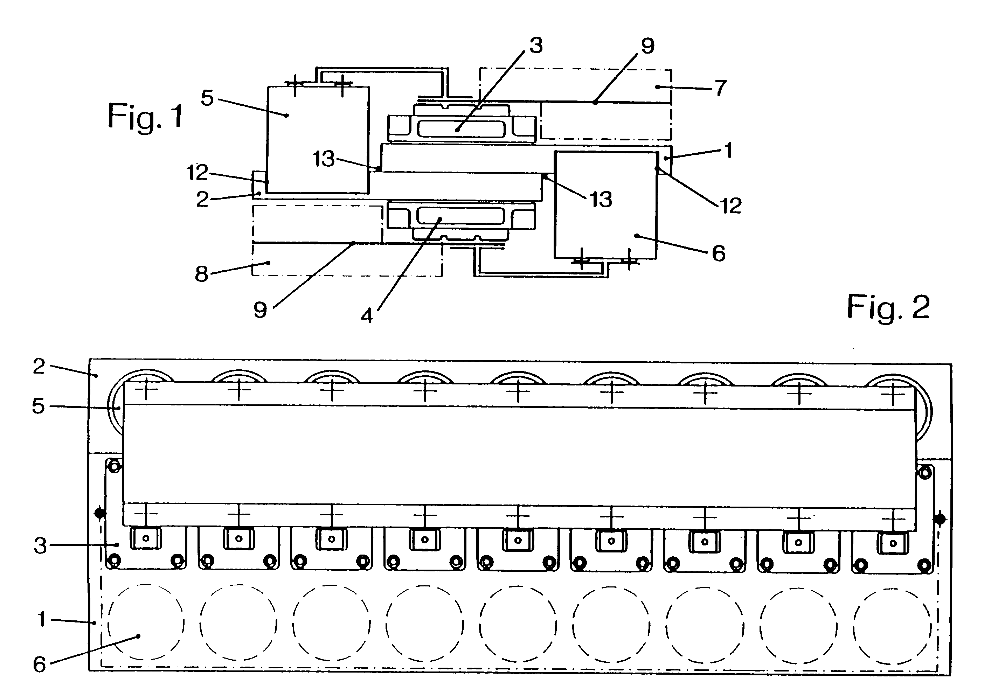

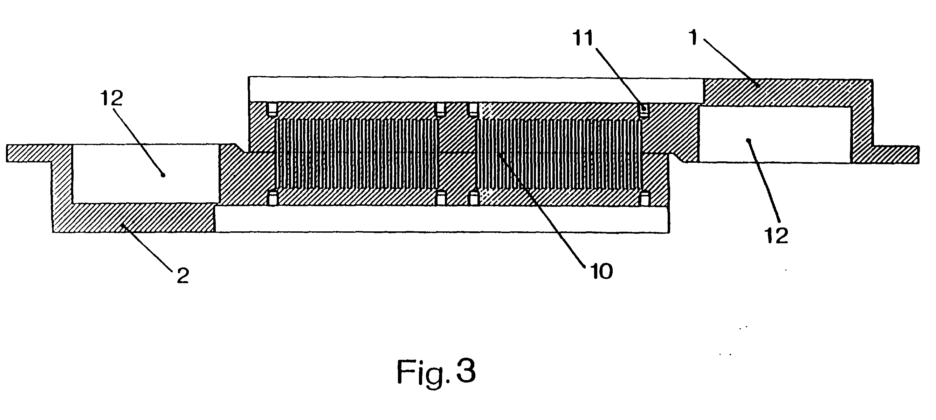

Die Fig. 1 zeigt eine Seitenansicht des Stromrichteraufbaus, Fig. 2 den zugehörigen Grundriß und Fig. 3 einen Schnitt, bei dem die Kühlkanäle zu erkennen sind.

Bei Fig. 1 und 2 sind die zwei Grundkörper 1,2 zu erkennen, wobei auf beiden die Halbleitermodule 3,4 und die Zwischenkreiskondensatoren 5,6 gleich angeordnet sind. Die Halbleitermodule 3,4 sind auf dem Grundkörper 1,2 entlang einer Längseite befestigt und auf der gegenüberliegenden Seite jedes Grundkörpers 1,2 auf der zweiten Längsseite sind in Vertiefungen die Zwischenkreiskondensatoren 5,6 vorgesehen. Beide Grundkörper 1,2 sind derart überlappend miteinander verbunden, daß die Halbleiterelemente 3,4, nur getrennt durch die doppelte Höhe der Grundkörper 1,2, gegenüber liegen. Die Zwischenkreiskondensatoren 5, 6 auf dem einen Grundkörper 1,2 sind mit den Halbleitermodulen 3,4 auf dem anderen Grundkörper 1,2 elektrisch verbunden. Die Ansteuerelektronik 7, 8 für die Halbleitermodule 3,4 befindet sich auf einer Leiterplatte 9 die parallel zum Grundkörper 1,2 liegt und direkt mit den Halbleitermodulen 3,4 verbunden ist.

Die Grundkörper 1,2 bestehen aus einem gut wärmeleitendem Material, welches entweder Kupfer, eine Kupfer- oder Aluminiumlegierung ist. Außerdem sollte das Grundkörpermaterial auch relativ einfach spanabhebend zu bearbeiten sein. Die beiden Grundkörper 1,2 sind entlang der Längsseiten entweder miteinander verlötet oder verschweißt (siehe 13).

Der Halbleitermodul 3,4 beinhaltet die zwei Transistoren, welche z.B. IGBT's (Insulated Gate Bipolar Transistor) sind, für eine Phase des Stromrichters und die jeweils parallelen Freilaufdioden. Die Transistoren und die Freilaufdioden sind intern gegenüber dem Gehäuse des Halbleitermodules 3,4 isoliert. Die beiden Grundkörper 1, 2 sind somit spannungslos.

In dem Schnitt in Fig. 3 durch zwei miteinander verbundene Grundkörper 1,2 sind die Längsschlitze 10 dargestellt. Die beiden Grundkörper 1,2 sind dabei so miteinander verbunden, daß die Längsschlitze 10 gegenüber liegen. Die Gewindelöcher 11 sind zur Befestigung der Halbleitermodule 3,4 vorgesehen, wobei die Grundkörper 1,2 für Halbleitermodule 3,4 in zwei Reihen ausgelegt sind, wodurch die Kompaktheit nochmals verbessert wird. Die Längsschlitze 10 reichen nur bis zum stirnseitigen Randbereich der Grundkörper 1,2 und sind dort mit nicht dargestellen Quervertiefungen untereinander verbunden. An jeder Stirnseite der Grundkörper 1,2 ist eine Bohrung vorgesehen, welche bis zur Quervertiefung reicht und deren Mittelpunkt auf der Verbindung zwischen den beiden Grundkörpern 1,2 liegt. Die Bohrungen sind für den Zuund Abfluß des flüssigen Kühlmediums notwendig. Für diese Kühlung der Grundkörper 1,2 müssen diese natürlich flüssigkeitsdicht miteinander verbunden sein.

Die Längsschlitze 10 und die Quervertiefungen werden üblicherweise gefräst. Es könnten aber auch die Grundkörper 1,2, wie sie in Fig. 3 dargestellt sind in Aluminiumdruckguß hergestellt sein.

## Patentansprüche

1. Stromrichter, der aus einzelnen Halbleitermodulen und Zwischenkreiskondensatoren besteht, wobei auf einem rechteckigen ersten Grundkörper (1) entlang einer Längsseite eine erste Mehrzahl von Halbleitermodulen (3) befestigt ist, welche in thermischem Kontakt mit dem ersten Grundkörper (1) stehen, und auf der Unterseite entlang der zweiten Längsseite eine erste Mehrzahl von Zwischenkreiskondensatoren (6) stehend angeordnet ist, welche ebenfalls in thermischem Kontakt mit dem ersten Grundkörper (1) stehen, und ein zweiter Grundkörper (2) vorgesehen ist, auf dem eine zweite Mehrzahl von Halbleitermodulen (4) und eine zweite Mehrzahl von Zwischenkreiskondensatoren (5) in der gleichen Art angeordnet ist, und daß beide Grundkörper (1, 2) überlappend entlang ihrer Längsseiten so miteinander verbunden sind, daß die Halbleitermodule (3, 4) gegenüber liegen, und die Zwischenkreiskondensatoren (5) auf dem einen Grundkörper (2) mit den Halbleitermodulen (3) auf dem anderen Grundkörper (1) elektrisch verbunden sind.

2. Stromrichter nach Anspruch 1, **dadurch gekennzeichnet,** daß die Zwischenkreiskondensatoren (5, 6) in Vertiefungen (12) in den Grundkörpern (1, 2) angeordnet sind.

3. Stromrichter nach Anspruch 1 oder 2, **dadurch gekennzeichnet,** daß die Halbleitermodule (3, 4) mit einer die Ansteuerung (7, 8) für diese aufweisenden Leiterplatte (9) verbunden sind, die parallel zu den Grundkörpern (1, 2) angeordnet ist.

4. Stromrichter nach einem der Ansprüche 1 bis 3, **dadurch gekennzeichnet,** daß jeder Grundkörper (1, 2) gegenüber den Halbleitermodulen (3, 4) Längsschlitze (10) aufweist, die durch Quervertiefungen im Randbereich der Grundkörper (1, 2) miteinander verbunden und abgeschlossen sind, und daß die Grundkörper (1, 2) derart miteinander verbunden sind, daß die Längsschlitze (10) gegenüber liegen, und daß an den Stirnseiten von den miteinander verbundenen Grundkörpern mindestens je eine Bohrung bis zur Quervertiefung vorgesehen ist, deren Mittelpunkt auf der Verbindung zwischen den Grundkörpern (1, 2) liegt, und daß die Bohrungen für den Zu- und Abfluß eines flüssigen Kühlmediums vorgesehen sind.

## Claims

1. An electric converter formed of semiconductor modules or intermediate circuit capacitors, with a first plurality of semiconductor modules (3) being fixed along a longitudinal edge on a first rectangular base body (1) and arranged in thermal contact with said first base body (1), and on the lower face thereof and along second longitudinal side thereof a first plurality of intermediate circuit capacitors (6) is vertically disposed, which is also in thermal contact with said first base body (1), and with a second base body (2) being provided on which a second plurality of semiconductor modules (4) and a second plurality of intermediate circuit capacitors (5) are similarly arranged, and in that both base bodies (1, 2) are connected together while overlapping one another along longitudinal sides thereof so that semiconductor modules (3, 4) are oppositely disposed, and with intermediate circuit capacitors (5) on a first base body (2) being electrically connected to semiconductor modules (3) on the other base body (1).

2. The electric converter as recited in claim 1, characterized in that intermediate circuit capacitors (5, 6) are arranged into cavities (12) of base bodies (1, 2).

3. The electric converter as recited in claim 1 or 2, characterized in that semiconductor modules (3, 4) are connected to a printed circuit board (9), having the control device (7, 8) therefor and which is placed parallely to base bodies (1, 2).

4. The electric converter as recited in one of claims 1-3, characterized in that each base body (1, 2) shows, in front of semiconductor modules (3, 4), longitudinal slots (10) which are connected together by transverse cavities in ledging area of base bodies (1, 2) and are closed, and in that base bodies (1, 2) are connected together so that said longitudinal slots (10) are oppositely placed, and in that there is respectively provided on front faces of said connected base bodies at least a perforation up to said transversal cavity, the center of which is located on the link between both base bodies (1, 2), and in that said perforations are provided for supplying and outletting a liquid refrigerant.

## Revendications

1. Convertisseur électrique, constitué de différents modules à semi-conducteur et condensateurs à circuit intermédiaire, une première pluralité de modules à semi-conducteur (3) étant fixée le long d'un côté longitudinal sur un premier corps de base (1) rectangulaire et est placée en contact thermique avec le premier corps de base (1), et en face inférieure le long du deuxième côté longitudinal est disposée verticalement une première pluralité de condensateurs à circuit intermédiaire (6), placée également en contact thermique avec le premier corps de base (1), et un deuxième corps de base (2) étant prévu, sur lequel une deuxième pluralité de modules à semi-conducteur (4) et une deuxième pluralité de condensateurs à circuit intermédiaire (5) est disposée de la même manière, et en ce que les deux corps de base (1, 2) sont reliés ensemble en chevauchement le long de leurs côtés longitudinaux, de manière que les modules à semi-conducteur (3, 4) soient placés les uns en regard des autres, et les condensateurs à circuit intermédiaire (5) se trouvant sur un premier corps de base (2) étant reliés électriquement aux modules à semi-conducteur (3) se trouvant sur l'autre corps de base (1).

2. Convertisseur électrique selon la revendication 1, caractérisé en ce que les condensateurs à circuit intermédiaire (5, 6) sont disposés dans des cavités (12) ménagées dans les corps de base (1, 2).

3. Convertisseur électrique selon la revendication 1 ou 2, caractérisé en ce que les modules à semi-conducteur (3, 4) sont reliés à une plaquette à circuit imprimé (9), présentant le dispositif de commande (7, 8) leur étant destiné et disposée parallèlement aux corps de base (1, 2).

4. Convertisseur électrique selon l'une des revendications 1 à 3, caractérisé en ce que chaque corps de base (1, 2) présente, en face des modules à semi-conducteur (3, 4), des fentes longitudinales (10), qui sont reliées ensemble par des cavités transversales ménagées dans la zone de bordure des corps de base (1, 2) et sont fermées, et en ce que les corps de base (1, 2) sont reliés ensemble de manière que les fentes longitudinales (10) soient placées les unes en face des autres, et en ce que, sur les faces frontales des corps de base reliés ensemble, est respectivement prévu au moins un perçage allant jusqu'à la cavité transversale et dont le centre est situé sur la liaison entre les deux corps de base (1, 2), et en ce que les perçages sont prévus pour l'amenée et l'évacuation d'un milieu de refroidissement liquide.
